# EUROPÄISCHE PATENTSCHRIFT

(11) **EP 2 603 536 B1**
(45) Veröffentlichungstag und Bekanntmachung des Hinweises auf die Patenterteilung: **16.09.2015**
(21) Anmeldenummer: 11739103.7
(22) Anmeldetag: 05.08.2011
(51) Int. Cl.: H01L 41/08

(54) **ELEKTROMECHANISCHER WANDLER, UMFASSEND EIN POLYURETHANPOLYMER MIT POLYESTER-UND/ODER POLYCARBONAT EINHEITEN**
ELECTROMECHANICAL TRANSDUCER COMPRISING A POLYURETHANE POLYMER WITH POLYESTER AND/OR POLYCARBONATE UNITS
TRANSDUCTEUR ÉLECTROMÉCANIQUE, COMPORTANT UN POLYMÈRE POLYURÉTHANNE DOTÉ D'UNITÉS POLYESTER ET/OU POLYCARBONATE

(30) Priorität: 09.08.2010 EP 10172247; 09.08.2010 EP 10172246
(43) Veröffentlichungstag der Anmeldung: 19.06.2013
(73) Patentinhaber: Bayer Intellectual Property GmbH, 40789 Monheim am Rhein (DE)
(72) Erfinder: WAGNER, Joachim, 51061 Köln (DE); JENNINGER, Werner, "-" (DE); DÖRR, Sebastian, 40593 Düsseldorf (DE)
(74) Vertreter: BIP Patents
(86) Internationale Anmeldenummer: PCT/EP2011/063571
(87) Internationale Veröffentlichungsnummer: WO 2012/019979

(56) Entgegenhaltungen:
- DE-A1-102007 059 858
- JP-A- 6 085 339
- JP-A- 7 240 544

## Beschreibung

Die vorliegende Erfindung betrifft einen elektromechanischen Wandler, umfassend ein durch eine erste Elektrode und eine zweite Elektrode kontaktiertes dielektrisches Elastomer, wobei das dielektrische Elastomer ein Polyurethanpolymer umfasst. Das Polyurethanpolymer umfasst hierbei mindestens eine Polyester- und/oder Polycarbonat-Einheit. Die Erfindung betrifft weiterhin ein Verfahren zur Herstellung eines solchen elektromechanischen Wandlers, die Verwendung des eingesetzten dielektrischen Elastomers sowie eine elektrische und/oder elektronische Vorrichtung, umfassend einen erfindungsgemäßen elektromechanischen Wandler.

Elektromechanische Wandler spielen eine wichtige Rolle bei der Umwandlung von elektrischer Energie in mechanische Energie und umgekehrt. Elektromechanische Wandler können daher als Sensoren, Aktuatoren und/oder Generatoren eingesetzt werden. Als Beispiel hierfür seien die in WO-A 2001/006575 genannten Systeme vorgestellt, welche vorgespannte Polymere einsetzen.

Eine Klasse von solchen Wandlern basiert auf elektroaktiven Polymeren. Es ist ein ständiges Ziel, die Eigenschaften der elektroaktiven Polymere, insbesondere den elektrischen Widerstand und die Durchbruchfestigkeit, zu erhöhen. Gleichzeitig soll aber die Mechanik der Polymere sie für Einsätze in elektromechanischen Wandlern geeignet machen.

Eine Möglichkeit der Erhöhung der Dielektrizitätskonstante ist die Zugabe von bestimmten Füllstoffen. So beschreibt WO-A 2008/095621 rußgefüllte Polyurethanmassen, die wenigstens bestehen aus Polyetherurethanen, in die Polyolkomponenten eingebaut sind, die zu 50-100 Gew.-% aus durch DMC-Katalyse hergestellten Polyalkylenoxiden, insbesondere Polypropylenoxiden, und 0-50 Gew.-% aus von Katalysatorresten freien Polyolen, insbesondere solchen, die destillativ oder durch Umkristallisation gereinigt sind, oder solchen, die nicht durch ringöffnende Polymerisation von Sauerstoffheterocyclen hergestellt wurden, aufgebaut sind. Weiterhin enthalten die Polyurethanmassen 0,1-30 Gew.-% Ruß.

Energiewandler aus filmbildenden wässrigen Polyurethandispersionen werden in WO-A 2009/074192 offenbart. Auch hier werden die hohen Dielektrizitätskonstanten und die guten mechanischen Eigenschaften der erhaltenen Polyurethanfilme hervorgehoben.

US-A 5977685, JP-A 07240544, JP-A 06085339 und JP-B 3026043 offenbaren elektromechanische Wandler enthaltend ein Polyurethan-Elastomer, hergestellt aus makromolekularen Polyolen, organischen Polyisocyanaten und Verbindungen zur Kettenverlängerung, wobei das molare Verhältnis der NCO-Gruppen des Polyisocyanats zu den OH-Gruppen des Polyols im Bereich von 1,5 zu 9 liegt.

Es besteht jedoch weiterhin der Bedarf an elektromechanischen Wandlern mit dielektrischen Elastomeren, die gleichzeitig hohe elektrische Widerstände und hohe Durchbruchfeldstärken aufweisen, um noch höhere Wirkungsgrade der Wandler zu erreichen. Zudem müssen die Eigenschaften im Hinblick auf Biegsamkeit und reversibler Verformbarkeit der dielektrischen Elastomere weiter verbessert werden.

Erfindungsgemäß vorgeschlagen wird daher ein elektromechanischer Wandler, umfassend ein durch eine erste Elektrode und eine zweite Elektrode kontaktiertes dielektrisches Elastomer, wobei das dielektrische Elastomer ein Polyurethanpolymer umfasst. Der erfindungsgemäße Wandler zeichnet sich dadurch aus, dass das Polyurethanpolymer erhältlich ist aus der Reaktion von
A) trifunktionelles Polyisocyanat mit Biuret- und/oder Isocyanurat-Struktur
mit B) einer Verbindung mit mindestens zwei isocyanatreaktiven Gruppen,
wobei die Verbindung mit mindestens zwei isocyanatreaktiven Gruppen B) Polyester- und/oder Polycarbonat-Einheiten umfasst, und
wobei die molaren Verhältnisse von Isocyanatgruppen in A) zu gegenüber isocyanatreaktiven Gruppen in B) von 0,8:1,0 bis 1,3:1,0, bevorzugt 0,9:1,0 bis 1,2:1,0 betragen.Überraschenderweise wurde gefunden, dass die im erfindungsgemäßen elektromechanischen Wandler vorgesehenen Polyurethanpolymere besonders hohe elektrische Widerstände in Verbindung mit hohen Durchbruchfeldstärken aufweisen. Gleichzeitig liegen die Polyurethane als weiche Elastomere vor. Die Kombination dieser Eigenschaften ergibt einen vorteilhaften Einsatz in elektromechanischen Wandlern.

Wenn eine mechanische Beanspruchung auf einen derartigen Wandler ausgeübt wird, so deformiert sich der Wandler beispielsweise entlang seiner Dicke und seiner Fläche und ein starkes elektrisches Signal kann an den Elektroden detektiert werden. Damit wird mechanische Energie in elektrische Energie umgewandelt. Der erfindungsgemäße Wandler kann folglich sowohl als Generator als auch als Sensor eingesetzt werden.

Unter Ausnutzung des entgegengesetzten Effekts, nämlich der Umwandlung von elektrischer Energie in mechanische Energie, kann der erfindungsgemäße Wandler andererseits gleichermaßen als Aktuator dienen.

Als Elektroden sind grundsätzlich alle Materialien geeignet, welche eine ausreichend hohe elektrische Leitfähigkeit aufweisen und vorteilhafterweise der Ausdehnung des dielektrischen Elastomers folgen können. Beispielsweise können die Elektroden aus einem elektrisch leitfähigen Polymer, aus Leittinte oder aus Ruß aufgebaut sein.

Dielektrische Elastomere im Sinne der vorliegenden Erfindung sind Elastomere, die ihre Form durch das Anlegen eines elektrischen Feldes ändern können. Im Fall von Elastomerfolien kann sich zum Beispiel die Dicke verringern, während es gleichzeitig zu einer Längenausdehnung der Folie in Flächenrichtung kommt.

Die Dicke der dielektrischen Elastomerschicht beträgt vorzugsweise ≥ 1 µm bis ≤ 500 µm und mehr bevorzugt ≥ 10 µm bis ≤ 150 µm. Sie kann einstückig oder mehrstückig aufgebaut sein. Beispielsweise kann eine mehrstückige Schicht durch Aufeinanderlaminieren von einzelnen Schichten erhalten werden.

Das dielektrische Elastomer kann neben dem erfindungsgemäß vorgesehenen Polyurethanpolymer noch weitere Inhaltsstoffe aufweisen. Solche Inhaltsstoffe sind beispielsweise Vernetzer, Verdicker, Colösemittel, Thixotropiermittel, Stabilisatoren, Antioxidantien, Lichtschutzmittel, Emulgatoren, Tenside, Klebstoffe, Weichmacher, Hydrophobierungsmittel, Pigmente, Füllstoffe und Verlaufshilfsmittel.

Füllstoffe im Elastomer können beispielsweise die Dielektrizitätskonstante des Polymers regulieren. Beispiele hierfür sind keramische Füllstoffe, insbesondere Bariumtitanat, Titandioxid und piezoelektrische Keramiken wie Quarz oder Bleizirkoniumtitanat, sowie organische Füllstoffe, insbesondere solche mit einer hohen elektrischen Polarisierbarkeit, beispielsweise Phthalocyanine.

Außerdem ist eine hohe Dielektrizitätskonstante auch durch das Einbringen elektrisch leitfähiger Füllstoffe unterhalb ihrer Perkolationsschwelle erzielbar. Beispiele hierfür sind Ruß, Graphit, einwandige oder mehrwandige Kohlenstoff-Nanoröhrchen, elektrisch leitfähige Polymere wie Polythiophene, Polyaniline oder Polypyrrole, oder Mischungen davon. In diesem Zusammenhang sind insbesondere solche Rußtypen von Interesse, die eine Oberflächenpassivierung aufweisen und deshalb bei niedrigen Konzentrationen unterhalb der Perkolationsschwelle zwar die Dielektrizitätskonstante erhöhen und trotzdem nicht zu einer Erhöhung der Leitfähigkeit des Polymers führen.

Das im erfindungsgemäßen elektromechanischen Wandler vorgesehene Polyurethanpolymer ist erhältlich ist aus der Reaktion von einem trifunktionellen Polyisocyanat mit Biuret- und/oder Isocyanurat-Struktur mit einer Verbindung B), welche mindestens zwei isocyanatreaktive Gruppen umfasst, und wobei die molaren Verhältnisse von Isocyanatgruppen in A) zu gegenüber isocyanatreaktiven Gruppen in B) von 0,8 : 1,0 bis 1,3 : 1,0, bevorzugt 0,9 : 1,0 bis 1,2 : 1,0 betragen. Hierbei weist B) die Polyester- und/oder Polycarbonat-Einheiten auf.

Die Polyester- und/oder Polycarbonat-Einheiten in dem Polyurethanpolymer lassen sich beispielsweise aus der Umsetzung von Polyisocyanaten A) mit Polyester- und/oder Polycarbonatpolyolen erhalten.

Als trifunktionelle Polyisocyanate mit Biuret- und/oder Isocyanurat-Struktur A) eignen sich erfindungsgemäß beispielsweise solche Verbindungen basierend auf 1,4-Butylendiisocyanat, 1,6 Hexamethylendiisocyanat (HDI), Isophorondiisocyanat (IPDI), 2,2,4 und/oder 2,4,4-Trimethylhexamethylendiisocyanat, die isomeren Bis-(4,4'-isocyanatocyclohexyl)methane oder deren Mischungen beliebigen Isomerengehalts, 1,4-Cyclohexylendiisocyanat, 4-Isocyanatomethyl-1,8-octandiisocyanat (Nonantriisocyanat), 1,4-Phenylendiisocyanat, 2,4-und/oder 2,6-Toluylendiisocyanat, 1,5-Naphthylendiisocyanat, 2,2'- und/oder 2,4'- und/oder 4,4'-Diphenylmethandiisocyanat, 1,3- und/oder 1,4-Bis-(2-isocyanato-prop-2-yl)-benzol (TMXDI), 1,3-Bis(isocyanatomethyl)benzol (XDI), Alkyl-2,6-diisocyanatohexanoate (Lysindiisocyanate) mit Alkylgruppen mit 1 bis 8 Kohlenstoffatomen sowie Mischungen davon. Bevorzugt eingesetzt werden Komponenten basierend auf 1,6 Hexamethylendiisocyanat (HDI), Isophorondiisocyanat (IPDI), Bis-(4,4'-isocyanatocyclohexyl)methan, Toluylendiisocyanat und/oder Diphenylmethandiisocyanat.

Im Rahmen der vorliegenden Erfindung kann Komponente B) grundsätzlich eine Verbindung mit mindestens zwei isocyanatreaktiven Gruppen, bevorzugt Amino- und/oder Hydroxygruppen, besonders bevorzugt Hydroxygruppen sein. Beispielsweise kann Komponente B) ein Polyol mit mindestens zwei isocyanatreaktiven Hydroxygruppen sein.

Polyester-Komponenten, die als Komponente B) eingesetzt werden können, sind die an sich bekannten Polykondensate aus Di- sowie gegebenenfalls Tri- und Tetraolen und Di- sowie gegebenenfalls Tri- und Tetracarbonsäuren oder Hydroxycarbonsäuren oder Lactonen. Anstelle der freien Polycarbonsäuren können auch die entsprechenden Polycarbonsäureanhydride oder entsprechende Polycarbonsäureester von niederen Alkoholen zur Herstellung der Polyester verwendet werden. Es werden bevorzugt Polyester-Polyole mit zahlenmittleren Molekulargewichten Mₙ von 400 bis 8000 g/mol, besonders bevorzugt 600 bis 3000 g/mol eingesetzt.

Beispiele für geeignete Diole zur Herstellung der Polyester-Polyole sind Ethylenglykol, Butylenglykol, Diethylenglykol, Triethylenglykol, Polyalkylenglykole wie Polyethylenglykol, weiterhin 1,2-Propandiol, 1,3-Propandiol, Butandiol(1,3), Butandiol(1,4), Hexandiol(1,6) und Isomere, Neopentylglykol oder Hydroxypivalinsäureneopentylglykolester, wobei Hexandiol(1,6) und Isomere, Butandiol(1,4), Neopentylglykol und Hydroxypivalinsäureneopentylglykolester bevorzugt sind. Daneben können auch Polyole wie Trimethylolpropan, Glycerin, Erythrit, Pentaerythrit, Trimethylolbenzol oder Trishydroxyethylisocyanurat eingesetzt werden.

Als Dicarbonsäuren zur Herstellung der Polyester-Polyole können beispielsweise Phthalsäure, Isophthalsäure, Terephthalsäure, Tetrahydrophthalsäure, Hexahydrophthalsäure, Cyclohexandicarbonsäure, Adipinsäure, Azelainsäure, Sebacinsäure, Glutarsäure, Tetrachlorphthalsäure, Maleinsäure, Fumarsäure, Itaconsäure, Malonsäure, Korksäure, 2-Methylbernsteinsäure, 3,3-Diethylglutarsäure und/oder 2,2-Dimethylbernsteinsäure eingesetzt werden. Als Säurequelle können auch die entsprechenden Anhydride verwendet werden.

Sofern die mittlere Funktionalität des zu veresternden Polyols > 2 ist, können zusätzlich auch Monocarbonsäuren, wie Benzoesäure und Hexancarbonsäure mit verwendet werden.

Bevorzugte Säuren zur Herstellung der Polyester-Polyole sind aliphatische und/oder aromatische Säuren der vorstehend genannten Art. Besonders bevorzugt sind Adipinsäure, Isophthalsäure und Phthalsäure.

Hydroxycarbonsäuren, die als Reaktionsteilnehmer bei der Herstellung eines Polyesterpolyols mit endständigen Hydroxylgruppen mitverwendet werden können, sind beispielsweise Hydroxycapronsäure, Hydroxybuttersäure, Hydroxydecansäure, Hydroxystearinsäure und dergleichen. Geeignete Lactone sind Caprolacton, Butyrolacton und Homologe. Bevorzugt ist Caprolacton.

Polycarbonat-Komponenten, die als Komponente B) eingesetzt werden können, sind hydroxylgruppen aufweisende Polycarbonate, bevorzugt Polycarbonatdiole, mit zahlenmittleren Molekulargewichten Mₙ von 400 bis 8000 g/mol, besonders bevorzugt 600 bis 3000 g/mol. Diese sind durch Reaktion von Kohlenstoffdioxid, Kohlensäurederivaten, wie Diphenylcarbonat, Dimethylcarbonat oder Phosgen, mit Polyolen, bevorzugt Diolen, erhältlich.

Beispiele derartiger Diole sind Ethylenglykol, 1,2- und 1,3-Propandiol, 1,3- und 1,4-Butandiol, 1,6-Hexandiol, 1,8-Octandiol, Neopentylglykol, 1,4-Bishydroxymethylcyclohexan, 2-Methyl-1,3-propandiol, 2,2,4-Trimethylpentandiol-1,3, Dipropylenglykol, Polypropylenglykole, Dibutylenglykol, Polybutylenglykole, Bisphenol A und lactonmodifizierte Diole der vorstehend genannten Art.

Bevorzugt enthält die Diolkomponente 40 bis 100 Gew.-% Hexandiol, bevorzugt sind 1,6-Hexandiol und/oder Hexandiolderivate. Solche Hexandiolderivate basieren auf Hexandiol und weisen neben endständigen OH-Gruppen Ester- oder Ethergruppen auf. Solche Derivate sind durch Reaktion von Hexandiol mit überschüssigem Caprolacton oder durch Veretherung von Hexandiol mit sich selbst zum Di- oder Trihexylenglykol erhältlich.

Statt oder zusätzlich zu reinen Polycarbonatdiolen können auch Polyether-Polycarbonatdiole eingesetzt werden. Hydroxylgruppen aufweisende Polycarbonate sind bevorzugt linear gebaut.

Im Rahmen der vorliegenden Erfindung werden die Begriffe "ein" und "eine" im Zusammenhang mit den Komponenten A) und B) nicht als Zahlwörter, sondern als unbestimmter Artikel verwendet.

In einer Ausführungsform des erfindungsgemäßen elektromechanischen Wandlers ist das Polyurethanpolymer erhältlich aus der Reaktion eines trifunktionellen Polyisocyanats mit Biuret- und/oder Isocyanurat-Struktur A) mit einem Polyester- und/oder Polycarbonat-Polyol B). Vorzugsweise basiert das trifunktionelle Polyisocyanat mit Biuret- und/oder Isocyanurat-Struktur jeweils auf einem aliphatischen Diisocyanat, besonders bevorzugt jeweils auf Hexamethylendiisocyanat.

In einer weiteren Ausführungsform des erfindungsgemäßen elektromechanischen Wandlers beträgt in dem Polyurethanpolymer der Anteil von Polyester- und/oder Polycarbonat-Einheiten ≥ 20 Gewichts-% bis ≤ 90 Gewichts-%. Vorzugsweise liegt dieser Anteil zwischen ≥ 25 Gewichts-% und ≤ 80 Gewichts-% und besonders bevorzugt zwischen ≥ 30 Gewichts-% und ≤ 50 Gewichts-%.

In einer weiteren Ausführungsform des erfindungsgemäßen elektromechanischen Wandlers weist das Polyurethanpolymer ein Elastizitätsmodul bei einer Dehnung von 50% von ≥ 0,1 MPa bis ≤ 15 MPa auf. Der Modul wird hierbei nach DIN EN 150 672 1-1 bestimmt und kann auch ≥ 0,2 MPa bis ≤ 5 MPa betragen. Weiterhin kann das Polyurethanpolymer eine maximale Spannung von ≥ 0,2 MPa, insbesondere von ≥ 0,4 MPa bis ≤ 50 MPa und eine maximale Dehnung von ≥ 250 %, insbesondere von ≥ 350 %, aufweisen. Darüber hinaus kann das erfindungsgemäße Polymerelement im Gebrauchsdehnungsbereich von ≥ 50 % bis ≤ 200 % eine Spannung von ≥ 0,1 MPa bis ≤ 1 MPa, beispielsweise von ≥ 0,15 MPa bis ≤ 0,8 MPa, insbesondere von ≥ 0,2 MPa bis ≤ 0,3 MPa, aufweisen (Bestimmung nach DIN 53504).

Ein weiterer Gegenstand der vorliegenden Erfindung ist ein Verfahren zur Herstellung eines elektromechanischen Wandlers, umfassend die Schritte:
1) Bereitstellen einer ersten Elektrode und einer zweiten Elektrode;
2) Bereitstellen eines dielektrischen Elastomers, wobei das dielektrische Elastomer ein Polyurethanpolymer umfasst, und das Polyurethanpolymer erhältlich ist aus der Reaktion von
   A) trifunktionelles Polyisocyanat mit Biuret- und/oder Isocyanurat-Struktur
      mit B) einer Verbindung mit mindestens zwei isocyanatreaktiven Gruppen,
      wobei die Verbindung mit mindestens zwei isocyanatreaktiven Gruppen B) Polyester- und/oder Polycarbonat-Einheiten umfassen, und
      wobei die molaren Verhältnisse von Isocyanatgruppen in A) zu gegenüber isocyanatreaktiven Gruppen in B) von 0,8 :.1,0 bis 1,3 : 1,0, bevorzugt 0,9 : 1,0 bis 1,2 : 1,0 betragen;
3) Anordnen des dielektrischen Elastomers zwischen die erste Elektrode und die zweite Elektrode.

Details zu dem Polyurethanpolymer einschließlich der Ausführungsformen wurden bereits im Zusammenhang mit der erfindungsgemäßen Vorrichtung beschrieben. Zur Vermeidung von unnötigen Wiederholungen wird bezüglich des Verfahrens auf dieses Bezug genommen.

Im erfindungsgemäßen Verfahren erfolgt das Bereitstellen des dielektrischen Elastomers bevorzugt durch Auftragen der zu dem Polyurethanpolymer führenden Reaktionsmischung auf die erste und/oder zweite Elektrode. Der Vorteil dieser Vorgehensweise ist insbesondere, dass das aushärtende Elastomer eine gute Haftung zu den Elektroden aufbauen kann.

Das Auftragen der Reaktionsmischung kann beispielsweise durch Rakeln, Streichen, Gießen, Schleudern, Sprühen oder Extrusion erfolgen.

Vorzugsweise wird nach Auftragen der Reaktionsmischung getrocknet und/oder getempert. Das Trocknen/Tempern kann dabei in einem Temperaturbereich von 0 °C bis 200 °C, beispielsweise für 0,1min bis 48 h, insbesondere für 6 h bis 18 h erfolgen; besonders bevorzugt ist eine Trocknung/Temperung für die Dauer von 15 min bis 30 min im Temperaturbereich von 60 °C bis 120 °C.

Die vorliegende Erfindung betrifft weiterhin die Verwendung eines dielektrischen Elastomers als Aktor, Sensor und/oder Generator in einem elektromechanischen Wandler, wobei das dielektrische Elastomer ein Polyurethanpolymer umfasst, und das Polyurethanpolymer erhältlich ist aus der Reaktion von
A) trifunktionelles Polyisocyanat mit Biuret- und/oder Isocyanurat-Struktur
   mit B) einer Verbindung mit mindestens zwei isocyanatreaktiven Gruppen,
   wobei die Verbindung mit mindestens zwei isocyanatreaktiven Gruppen B) Polyester- und/oder Polycarbonat-Einheiten umfassen, und
   wobei die molaren Verhältnisse von Isocyanatgruppen in A) zu gegenüber Isocyanat reaktiven Gruppen in B) von 0,8 : 1,0 bis 1,3 : 1,0, bevorzugt 0,9 : 1 bis 1,2 : 1, betragen.

Details zu dem Polyurethanpolymer einschließlich der Ausführungsformen wurden bereits im Zusammenhang mit der erfindungsgemäßen Vorrichtung beschrieben. Zur Vermeidung von unnötigen Wiederholungen wird bezüglich dessen Verwendung hierauf Bezug genommen.

Verwendungen finden sich in einer Vielzahl von verschiedensten Anwendungen im elektromechanischen und elektroakustischen Bereich, insbesondere im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie. Typische Beispiele hierfür sind Drucksensoren, elektroakustische Wandler, Mikrophone, Lautsprecher, Schwingungswandler, Lichtdeflektoren, Membrane, Modulatoren für Glasfaseroptik, pyroelektrische Detektoren, Kondensatoren und Kontrollsysteme und "intelligente" Fußböden sowie Systeme zur Umwandlung von Wasserwellenenergie, insbesondere Meereswellenenergie, in elektrische Energie.

Ein weiterer Gegenstand der Erfindung ist eine elektrische und/oder elektronische Vorrichtung, umfassend einen erfindungsgemäßen elektromechanischen Wandler.

### Beispiele

Sofern nicht abweichend gekennzeichnet, beziehen sich alle Prozentangaben auf das Gewicht und alle analytischen Messungen beziehen sich auf Temperaturen von 23 °C. NCO-Gehalte wurden, wenn nicht ausdrücklich anders erwähnt, volumetrisch gemäß DIN-EN ISO 11909 bestimmt.

Die angegebenen Viskositäten wurden mittels Rotationsviskosimetrie nach DIN 53019 bei 23 °C mit einem Rotationsviskosimeter der Firma Anton Paar Germany GmbH bestimmt.

Die Zugversuche wurden mittels einer Zugmaschine der Firma Zwick, Modell Nummer 1455, ausgestattet mit einer Kraftmessdose des Gesamtmessbereiches 1 kN nach DIN 53 504 mit einer Zuggeschwindigkeit von 50 mm/min ausgeführt. Als Probekörper wurden S2-Zugstäbe eingesetzt. Jede Messung wurde an drei gleichartig präparierten Probekörpern ausgeführt und der Mittelwert der erhaltenen Daten zur Bewertung verwendet. Es wurde die Spannung in [MPa] bei 50 % Dehnung bestimmt.

Die Bestimmung des elektrischen Widerstandes geschah mittels eines Laboraufbaus der Firma Keithley Instruments, Modell Nr.: 6517 A und 8009, gemäß ASTM D 257 (einer Methode zur Bestimmung des Isolationswiderstandes von Werkstoffen).

Die Bestimmung der Durchbruchsfeldstärke gemäß ASTM D 149-97a wurde mit einer Hochspannungsquelle Modell hypotMAX der Firma Associated Research Inc. und einem eigenkonstruierten Probenhalter durchgeführt. Der Probenhalter kontaktiert die homogen dicken Polymerproben mit nur geringer mechanischer Vorbelastung und verhindert, dass der Bediener in Kontakt mit der Spannung kommt. Die nicht vorgespannte Polymerfolie wurde in diesem Aufbau mit steigender Spannung statisch belastet, bis ein elektrischer Durchbruch durch die Folie erfolgte. Das Messergebnis ist die beim Durchbruch erreichte Spannung, bezogen auf die Dicke der Polymerfolie in [V/µm]. Es wurden je Folie 5 Messungen ausgeführt und der Mittelwert angegeben.

### Verwendete Substanzen und Abkürzungen:

- Desmodur® N 100:: trifunktionelles Biuret auf Basis von Hexamethylendiisocyanat (HDI-Biuret), NCO-Gehalt 21,95 ± 0,3 % (nach DIN EN ISO 11 909), Viskosität bei 23 °C 9630 ± 750 mPa·s, Bayer MaterialScience AG, Leverkusen, DE.
- Desmodur® N 3300:: trifunktionelles Isocyanurat auf Basis von Hexamethylendiisocyanat (HDI-Trimer), NCO-Gehalt 21,8 ± 0,3 % (nach DIN EN ISO 11 909), Viskosität bei 23 °C 3000 ± 750 mPa·s, Bayer MaterialScience AG, Leverkusen, DE
- Desmodur® 44M: 4,4'-Methylendiphenyldiisocyanat, Bayer MaterialScience AG, Leverkusen, DE.
- Desmodur® XP 2599: Aliphatisches, Ethergruppen enthaltendes Prepolymer auf Basis von HDI, Bayer MaterialScience AG, Leverkusen, DE
- Terathane® 2000: Polytetramethylenetherglykol mit Mₙ = 2000 g/mol, INVISTA Resins & Fibers, Hattersheim am Main, DE
- Terathane® 2900: Polytetramethylenetherglykol mit Mₙ = 2900 g/mol, INVISTA Resins & Fibers, Hattersheim am Main, DE
- Terathane® 650: Polytetramethylenetherglykol mit Mₙ = 650 g/mol, INVISTA Resins & Fibers, Hattersheim am Main, DE
- PolyTHF® 2000: difunktioneller Polytetraethylenglykol-Polyether mit Mₙ = 2000 g/mol, BASF SE, Ludwigshafen, DE
- PolyTHF® 2900: difunktioneller Polytetraethylenglykol-Polyether mit Mₙ = 2900 g/mol, BASF SE, Ludwigshafen, DE
- Arcol® PPG 2000: difunktioneller Polypropylenglykol-Polyether mit Mₙ = 2000 g/mol, Bayer MaterialScience AG, Leverkusen, DE
- Acclaim® 6320: trifunktioneller Polypropylenoxid-polyethylenoxid-Polyether mit Mₙ = 6000 g/mol und einem Anteil an Ethylenoxid-Einheiten von 20 Gewichts-%, Bayer MaterialScience AG, Leverkusen, DE
- Acclaim® 6300: trifunktioneller Polypropylenoxid-Polyether mit Mₙ = 6000 g/mol, Bayer MaterialScience AG, Leverkusen, DE
- Desmophen® 670: Schwach verzweigter, hydroxylgruppenhaltiger Polyester, Hydroxylgehalt 4,3 ± 0,4 % (DIN 53 240/2), Bayer MaterialScience AG, Leverkusen, DE.
- Desmophen® P 200 H/DS: Linearer, hydroxylgruppenhaltiger Polyester, Bayer MaterialScience AG, Leverkusen, DE.
- Desmophen® C 2200: Lineares, aliphatisches Polycarbonatdiol mit endständigen Hydroxylgruppen und einem Molekulargewicht von ca. 2000 g/mol, Bayer MaterialScience AG, Leverkusen, DE.
- Desmophen® C 2201: Polyester aus Hexandiol-dimethylcarbonat mit einem Molekulargewicht von ca. 2000 g/mol, Bayer MaterialScience AG, Leverkusen, DE.
- Desmophen®2001KS: Polyesterpolyol mit einem Molekulargewicht von ca. 2000 g/mol Polyethylen/Polybutylen-Adipatdiol, Bayer MaterialScience AG, Leverkusen, DE.
- Mesamoll®: Alkylsulfonsäureester des Phenols, Lanxess Deutschland GmbH, Leverkusen, DE
- DBTDL: Dibutyl-zinn-dilaurat, E. Merck KGaA , Darmstadt, DE.
- Desmorapid® SO: Zinn(II)-2-ethylhexanoat, Bayer MaterialScience AG, Leverkusen, DE
- Irganox® 1076: Octadecyl-3-(3,5-di-tert.butyl-4-hydroxyphenyl)-propionat, Ciba Specialty Chemicals Inc., Basel, CH
- Fascat® 4102: Butylzinn-tris-2-ethylhexanoat, Arkema Inc. Philadelphia, USA

### Beispiel 1: Herstellung eines di-isocyanatfunktionellen Polyisocyanat-Prepolymers

1300 g Hexamethylen-1,6-diisocyanat (HDI) und 0,27 g Dibutylphosphat wurden in einem 4 Liter Vierhalskolben unter Rühren vorgelegt. Innerhalb von 3 Stunden fügte man bei 80 °C 1456 g Arcol® PPG 2000 hinzu und rührte 1 Stunde bei gleicher Temperatur nach. Anschließend wurde durch Dünnschichtdestillation bei 130 °C und 0,1 Torr das überschüssige HDI abdestilliert. Das erhaltene NCO-Prepolymer hatte einen NCO-Gehalt von 3,27 % und eine Viskosität von 1680 mPas (25 °C).

### Beispiel 2: Herstellung eines tetra-isocyanatfunktionellen Polyisocyanat-Prepolymers

1000 g Hexamethylen-1,6-diisocyanat (HDI) und 0,15 g Zirkonoktoat wurden in einem 4 Liter Vierhalskolben unter Rühren vorgelegt. Dann fügte man bei 80 °C 1000 g PolyTHF® 2000 hinzu und rührte 5 Stunden bei 115 °C nach, wobei noch 3 Mal im Stundenabstand 0,15 g Zirkonoktoat zugesetzt wurden. Nach Ablauf der Zeit wurden 0,5 g Dibutylphosphat zugesetzt. Anschließend wurde durch Dünnschichtdestillation bei 130 °C und 0,1 Torr das überschüssige HDI abdestilliert. Das erhaltene NCO-Prepolymer hatte einen NCO-Gehalt von 6,18 % und eine Viskosität von 25700 mPas (25 °C).

### Beispiel 3: Herstellung eines di-isocyanatfunktionellen Polyisocyanat-Prepolymers

Zur Herstellung des Prepolymers wurden 7,15 kg Desmodur 44M® in einem Rührwerksbehälter bei einer Temperatur von 50 °C vorgelegt und 45,85 kg des auf Raumtemperatur temperierten Polyethers Acclaim 6300® innerhalb von 15 Minuten zugegeben (wahlweise könnte aber auch der Polyether bei 50 °C vorgelegt und danach das ebenfalls auf 50 °C erwärmte Isocyanat zugegeben werden).

Danach wurde zur Reaktion auf 100 °C aufgeheizt und weitere 7 Stunden bei dieser Temperatur gehalten. Nach dem Abkühlen erhielt man ein Produkt mit einem NCO-Gehalt von 2,70 ± 0,1Gewichts-% und einer Viskosität bei 70°C von ca. 4200 ± 600 mPas.Beispiel 4 (Vergleich): **Herstellung eines nicht erfindungsgemäß zu verwendenden Polymers**

Die eingesetzten Rohstoffe wurden nicht separat entgast. 8,65 g eines Prepolymeren aus Beispiel 2 und 25,0 g Acclaim® 6320 wurden mit einer Menge von 0,075 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Beispiel 5 (Vergleich): Herstellung eines nicht erfindungsgemäß zu verwendenden Polymers

Die eingesetzten Rohstoffe wurden nicht separat entgast. 5,0 g Desmodur® N 3300 und 20,0 g des Prepolymers aus Beispiel 1 wurden in einem Polypropylen-Becher eingewogen und im Speedmixer bei 3000 Umdrehungen pro Minute für 1 Minute miteinander vermischt. Diese Mischung wurde dann mit 38,54 g Terathane® 2000 mit einer Menge von 0,01 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Beispiel 6 (Vergleich): Herstellung eines nicht erfindungsgemäß zu verwendenden Polymers

Die eingesetzten Rohstoffe wurden nicht separat entgast. 19,94 g des Prepolymeren aus Beispiel 2 und 30,0 g Terathane® 2000 wurden mit einer Menge von 0,03 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Beispiel 7 (Vergleich) : Herstellung eines nicht erfindungsgemäß zu verwendenden Polymers

Die eingesetzten Rohstoffe wurden nicht separat entgast. 14,27 g des Prepolymeren aus Beispiel 2 wurde mit 30,0 g Terathane® 2900 und einer Menge von 0,03 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Beispiel 8 (Vergleich) : Herstellung eines nicht erfindungsgemäß zu verwendenden Polymers

Die eingesetzten Rohstoffe wurden nicht separat entgast. 1,96 g des Desmodur® N3300 wurde mit 10,0 g Terathane® 2000 und einer Menge von 0,005 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Beispiel 9 (Vergleich): Herstellung eines nicht erfindungsgemäß zu verwendenden Polymers

Die eingesetzten Rohstoffe wurden nicht separat entgast. 6,7 g Desmodur® N3300 wurde mit 50,0 g Terathane® 2900 und einer Menge von 0,05 g DBTDL in einem Polypropylen-Becher im Speedmixer bei 3000 Umdrehungen pro Minute für die Dauer von 1 Minute vermischt. Aus dem noch flüssigen Reaktionsgemisch wurden auf Glasplatten von Hand Filme einer Nassschichtdicke von 1 mm gerakelt. Alle Filme wurden nach der Herstellung bei 80 °C im Trockenschrank über Nacht getrocknet und anschließend 5 min bei 120 °C nachgetempert. Die Filme konnten nach dem Tempern von Hand einfach von der Glasplatte gelöst werden.

### Beispiel 10 (Vergleich): Herstellung eines nicht erfindungsgemäß zu verwendenden Polymers

Die eingesetzten Rohstoffe wurden nicht separat entgast. 25 g Desmophen® 2001 KS wurden mit 0,025 g Irganox® 1076 in einem PP-Becher bei 60°C im Speedmixer bei 3000 Umdrehungen pro Minute vermischt. Nachdem der Stabilisator vollständig gelöst war, wurde 0,025 g DBTDL zugegeben und erneut im Speedmixer bei 3000 Umdrehungen pro Minute für die Dauer von 1 Minute vermischt. Danach wurden 38,964 g des Prepolymeren aus Beispiel 1 zugegeben und erneut im Speedmixer bei 3000 Umdrehungen pro Minute für die Dauer von 1 Minute vermischt.

Aus dem noch flüssigen Reaktionsgemisch wurden mittels eines automatischen Filmziehgerätes (Typ ZAA 2300, Zinser Analytik) auf einer silikonisierten Folie RN 75 2SLK Filme einer Nassschichtdicke von 0,25 mm gerakelt. Alle Filme wurden nach der Herstellung bei 100 °C im Trockenschrank für die Dauer von 1 h getempert.

### Beispiel 11 (Vergleich): Herstellung eines nicht erfindungsgemäß zu verwendenden Polymers

Die eingesetzten Rohstoffe wurden nicht separat entgast. 50 g Desmophen® C2201 wurden mit 0,05 g Irganox® 1076 bei 100°C im Speedmixer bei 3000 Umdrehungen pro Minute vermischt. Nachdem der Stabilisator vollständig gelöst war, wurde 0,5 g Desmorapid® SO zugegeben und erneut im Speedmixer bei 3000 Umdrehungen pro Minute für die Dauer von 1 Minute vermischt. Danach wurden 34,305 g Desmodur® XP2599 zugegeben und erneut im Speedmixer bei 3000 Umdrehungen pro Minute für die Dauer von 1 Minute vermischt.

Aus dem noch flüssigen Reaktionsgemisch wurden mittels eines automatischen Filmziehgerätes (Typ ZAA 2300, Zinser Analytik) auf einer silikonisierten Folie RN 75 2SLK Filme einer Nassschichtdicke von 0,25 mm gerakelt. Alle Filme wurden nach der Herstellung bei 100 °C im Trockenschrank für die Dauer von 1 h getempert.

### Beispiel 12: Herstellung eines erfindungsgemäß zu verwendenden Polymers

Die eingesetzten Rohstoffe wurden nicht separat entgast. 50,0 g Desmophen^{®} 670 und 0,05 g Irganox^{®} 1076 wurden in einem Polypropylen-Becher eingewogen, im Speedmixer bei 3000 Umdrehungen pro Minute für die Dauer von 1 Minute vermischt und danach auf 60 °C vorgewärmt. Nachdem der Stabilisator Irganox^{®} 1076 vollständig gelöst ist, wurde 0,025 g Desmorapid^{®} SO zugegeben und diese Mischung nochmals für die Dauer von 1 min bei 3000 Umdrehungen pro Minute homogenisiert. Zu dieser homogenen Mischung wurde 25,24 g Desmodur^{®} N 100 hinzugewogen und dieses Gemisch erneut im Speedmixer bei 3000 Umdrehungen pro Minute für die Dauer von 1 Minute vermischt.

Aus dem noch flüssigen Reaktionsgemisch wurden auf Glasplatten von Hand Filme einer Nassschichtdicke von 1 mm gerakelt. Alle Filme wurden nach der Herstellung bei 100 °C im Trockenschrank für die Dauer von 1 h gehärtet. Die Filme konnten nach dem Härten von Hand einfach von der Glasplatte gelöst werden.

### Beispiel 13: Herstellung eines erfindungsgemäß zu verwendenden Polymers

Die eingesetzten Rohstoffe wurden nicht separat entgast. 50,0 g Desmophen^{®} C2201 und 0,05 g Irganox^{®} 1076 wurden in einem Polypropylen-Becher eingewogen, im Speedmixer bei 3000 Umdrehungen pro Minute für die Dauer von 1 Minute vermischt und danach auf 60 °C vorgewärmt. Nachdem der Stabilisator Irganox® 1076 vollständig gelöst ist, wurde 0,01 g DBTDL zugegeben und diese Mischung nochmals für die Dauer von 1 min bei 3000 Umdrehungen pro Minute homogenisiert. Zu dieser homogenen Mischung wurde 10,79 g Desmodur^{®} N 3300 hinzugewogen und dieses Gemisch erneut im Speedmixer bei 3000 Umdrehungen pro Minute für die Dauer von 1 Minute vermischt.

Aus dem noch flüssigen Reaktionsgemisch wurden auf Glasplatten von Hand Filme einer Nassschichtdicke von 1 mm gerakelt. Alle Filme wurden nach der Herstellung bei 100 °C im Trockenschrank für die Dauer von 1 h gehärtet. Die Filme konnten nach dem Härten von Hand einfach von der Glasplatte gelöst werden.

### Beispiel 14: Herstellung eines erfindungsgemäß zu verwendenden Polymers

Die eingesetzten Rohstoffe wurden nicht separat entgast. 50,0 g Desmophen^{®} C2200 und 0,05 g Irganox^{®} 1076 wurden in einem Polypropylen-Becher eingewogen, im Speedmixer bei 3000 Umdrehungen pro Minute für die Dauer von 1 Minute vermischt und danach auf 60 °C vorgewärmt. Nachdem der Stabilisator Irganox^{®} 1076 vollständig gelöst ist, wurde 0,15 g Desmorapid^{®} SO zugegeben und diese Mischung nochmals für die Dauer von 1 min bei 3000 Umdrehungen pro Minute homogenisiert. Zu dieser homogenen Mischung wurde 11,48 g Desmodur^{®} N 100 hinzugewogen und dieses Gemisch erneut im Speedmixer bei 3000 Umdrehungen pro Minute für die Dauer von 1 Minute vermischt.

Aus dem noch flüssigen Reaktionsgemisch wurden auf Glasplatten von Hand Filme einer Nassschichtdicke von 1 mm gerakelt. Alle Filme wurden nach der Herstellung bei 100 °C im Trockenschrank für die Dauer von 1 h gehärtet. Die Filme konnten nach dem Härten von Hand einfach von der Glasplatte gelöst werden.

### Beispiel 15: Herstellung eines erfindungsgemäß zu verwendenden Polymers

Die eingesetzten Rohstoffe wurden nicht separat entgast. 50 g Desmophen^{®} C2201 wurden mit 0,05 g Irganox^{®} 1076 bei 100°C im Speedmixer bei 3000 Umdrehungen pro Minute vermischt. Nachdem der Stabilisator vollständig gelöst war, wurde 0,007 g DBTDL zugegeben und erneut im Speedmixer bei 3000 Umdrehungen pro Minute für die Dauer von 1 Minute vermischt. Danach wurden 10,716 g Desmodur^{®} N100 zugegeben und erneut im Speedmixer bei 3000 Umdrehungen pro Minute für die Dauer von 1 Minute vermischt.

Aus dem noch flüssigen Reaktionsgemisch wurden mittels eines automatischen Filmziehgerätes (Typ ZAA 2300, Zinser Analytik) auf einer silikonisierten Folie RN 75 2SLK Filme einer Nassschichtdicke von 0,25 mm gerakelt. Alle Filme wurden nach der Herstellung bei 100 °C im Trockenschrank für die Dauer von 1 h getempert.

### Beispiel 16: Herstellung eines erfindungsgemäß zu verwendenden Polymers

Die eingesetzten Rohstoffe wurden nicht separat entgast. 50,0 g Desmophen^{®} P 200 H/DS flüssig und 0,05 g Desmorapid® SO wurden in einem Polypropylen-Becher eingewogen, auf 60 °C vorgewärmt und im Speedmixer bei 3000 Umdrehungen pro Minute für die Dauer von 20 Minuten vermischt. Nachdem der Stabilisator Irganox® 1076 vollständig gelöst ist, wurde 0,0025 g Fascat^{®} 4102 zugegeben und diese Mischung nochmals für die Dauer von 1 min bei 3000 Umdrehungen pro Minute homogenisiert. Zu dieser homogenen Mischung wurde 10,72 g Desmodur^{®} N 100 hinzugewogen und dieses Gemisch erneut im Speedmixer bei 3000 Umdrehungen pro Minute für die Dauer von 1 Minute vermischt.

Aus dem noch flüssigen Reaktionsgemisch wurden mittels eines automatischen Filmziehgerätes (Typ ZAA 2300, Zinser Analytik) auf einer silikonisierten Folie RN 75 2SLK Filme einer Nassschichtdicke von 0,25 mm gerakelt. Alle Filme wurden nach der Herstellung bei 100 °C im Trockenschrank für die Dauer von 1 h getempert.

### Beispiel 17: Herstellung eines erfindungsgemäß zu verwendenden Polymers

Die eingesetzten Rohstoffe wurden nicht separat entgast. 40,0 g Desmophen^{®} 670 15 g Mesamoll^{®} und 0,05 g Irganox^{®} 1076 wurden in einem Polypropylen-Becher eingewogen, im Speedmixer bei 3000 Umdrehungen pro Minute für die Dauer von 20 Minute vermischt und danach auf 60 °C vorgewärmt. Nachdem der Stabilisator Irganox^{®} 1076 vollständig gelöst ist, wurde 0,012 g Desmorapid^{®} SO zugegeben und diese Mischung nochmals für die Dauer von 1 min bei 3000 Umdrehungen pro Minute homogenisiert. Zu dieser homogenen Mischung wurde 22,18 g Desmodur^{®} N 100 hinzugewogen und dieses Gemisch erneut im Speedmixer bei 3000 Umdrehungen pro Minute für die Dauer von 1 Minute vermischt.

Aus dem noch flüssigen Reaktionsgemisch wurden mittels eines automatischen Filmziehgerätes (Typ ZAA 2300, Zinser Analytik) auf einer silikonisierten Folie RN 75 2SLK Filme einer Nassschichtdicke von 0,25 mm gerakelt. Alle Filme wurden nach der Herstellung bei 100 °C im Trockenschrank für die Dauer von 1 h getempert.

### Beispiel 18: Herstellung eines erfindungsgemäß zu verwendenden Polymers

50,0 g Desmophen^{®} P 200 H/DS flüssig, 0,05 g Desmorapid^{®} SO und 0,05 g Irganox^{®} 1076 wurden in einem Polypropylen-Becher eingewogen, auf 60 °C vorgewärmt und im Speedmixer bei 3000 Umdrehungen pro Minute für die Dauer von 20 Minute vermischt. Nachdem der Stabilisator Irganox^{®} 1076 vollständig gelöst ist, wurde zu dieser homogenen Mischung 10,79 g Desmodur^{®} N 3300 hinzugewogen und dieses Gemisch erneut im Speedmixer bei 3000 Umdrehungen pro Minute für die Dauer von 1 Minute vermischt.

Aus dem noch flüssigen Reaktionsgemisch wurden mittels eines automatischen Filmziehgerätes (Typ ZAA 2300, Zinser Analytik) auf einer silikonisierten Folie RN 75 2SLK Filme einer Nassschichtdicke von 0,25 mm gerakelt. Alle Filme wurden nach der Herstellung bei 100 °C im Trockenschrank für die Dauer von 1 h getempert.

An den Proben wurden der elektrische Widerstand und die Durchbruchsfeldstärke bestimmt. Die Ergebnisse für die nicht erfindungsgemäßen Beispiele und die Beispiele für erfindungsgemäße Polymerelemente sind in der nachfolgenden Tabelle 1 dargestellt. Zahlenwerte der Volumenwiderstände sind in Exponentialschreibweise angegeben. So bedeutet der Zahlenwert zum Beispiel 4 einen Volumen-Widerstand von 7,46 · 10¹⁰ Ohm cm. Weiterhin zeigt die Tabelle 1 die Elastizitätsmodule der Polymere bei 50 % Dehnung gemäß DIN EN 150 672 1-1.

**Tabelle 1: Eigenschaften der in den Beispielen 4 bis 11 (Vergleich) und 12-18 (erfindungsgemäß) hergestellten Filme**

| **Beispiel** | **Volumen-Widerstand [Ohm cm]** | **Durchbruchsfeldstärke [V/µm]** | **E-Modul [MPa]** |
|---|---|---|---|
| 4 (Vgl.) | 7,46E+10 | 32,0 | 0,60 |
| 5 (Vgl.) | 2,15E+11 | 45,8 | 0,95 |
| 6 (Vgl.) | 5,256E+12 | 57,0 | 1,84 |
| 7 (Vgl.) | 3,216E+12 | 55,4 | 1,66 |
| 8 (Vgl.) | 1,002E+11 | 26,1 | 1,89 |
| 9 (Vgl.) | 3,318E+12 | 64,0 | 1,77 |
| 10 (Vgl) | 5,803E+11 | 34,1 | 0,70 |
| 11 (Vgl) | 3,818E+11 | 30,3 | 0,81 |
| 12 | 5,16E+15 | 82,5 | 10,26 |
| 13 | 1,435E+14 | 69,4 | 2,22 |
| 14 | 9,10E+13 | 72,4 | 1,99 |
| 15 | 7,83E+14 | 132,6 | 2,39 |
| 16 | 4,10E+14 | 96,7 | 1,57 |
| 17 | 2,99E+14 | 104,0 | 2,85 |
| 18 | 4,97E+13 | 93,6 | 1,52 |

Es zeigte sich bei den Versuchen, dass das erfindungsgemäße Polymer als Film deutliche Vorteile gegenüber dem Stand der Technik aufweist.

Besonders vorteilhaft bei Einsatz des erfindungsgemäßen Films ist die Kombination aus sehr hohem elektrischen Widerstand, hoher Durchbruchsfeldstärke und hohem Modul. Mit diesem erfindungsgemäßen Polymer können vorteilhaft besonders günstige Wirkungsgrade der damit hergestellten elektromechanischen Wandler erzielt werden.

## Patentansprüche

1. Elektromechanischer Wandler, umfassend ein durch eine erste Elektrode und eine zweite Elektrode kontaktiertes dielektrisches Elastomer, wobei das dielektrische Elastomer ein Polyurethanpolymer umfasst, **dadurch gekennzeichnet, dass** das Polyurethanpolymer erhältlich ist aus der Reaktion von
A) trifunktionelles Polyisocyanat mit Biuret- und/oder Isocyanurat-Struktur
mit B) einer Verbindung mit mindestens zwei isocyanatreaktiven Gruppen,
wobei die Verbindung mit mindestens zwei isocyanatreaktiven Gruppen B) Polyester- und/oder Polycarbonat-Einheiten umfassen, und
wobei die molaren Verhältnisse von Isocyanatgruppen in A) zu gegenüber isocyanatreaktiven Gruppen in B) von 0,8 : 1,0 bis 1,3 : 1,0 betragen.

2. Elektromechanischer Wandler gemäß Anspruch 1, wobei Komponente A) auf einem aliphatischen trifunktioenllen Polyisocyanat mit Biuret- und/oder Isocyanurat-Struktur basiert.

3. Elektromechanischer Wandler gemäß Anspruch 1 oder 2, wobei Komponente A) auf Hexamethylendiisocyanat basiert.

4. Elektromechanische Wandler gemäß einem der Ansprüche 1 bis 3, **dadurch gekennzeichnet, dass** Komponente B) ein Polyester- und/oder Polycarbonat-Polyol ist.

5. Elektromechanischer Wandler gemäß einem der Ansprüche 1 bis 4, wobei in dem Polyurethanpolymer der Anteil von Polyester und/oder Polycarbonat-Einheiten ≥ 20 Gewichts-% bis ≤ 90 Gewichts-% beträgt.

6. Elektromechanischer Wandler gemäß einem der Ansprüche 1 bis 5, wobei das Polyurethanpolymer ein Elastizitätsmodul bei einer Dehnung von 50 % von ≥ 0,1 MPa bis ≤ 15 MPa aufweist.

7. Verfahren zur Herstellung eines elektromechanischen Wandlers, umfassend die Schritte:
1) Bereitstellen einer ersten Elektrode und einer zweiten Elektrode;
2) Bereitstellen eines dielektrischen Elastomers, wobei das dielektrische Elastomer ein Polyurethanpolymer umfasst, und das Polyurethanpolymer erhältlich ist aus der Reaktion von
A) trifunktionelles Polyisocyanat mit Biuret- und/oder Isocyanurat-Struktur
mit B) einer Verbindung mit mindestens zwei isocyanatreaktiven Gruppen,
wobei die Verbindung mit mindestens zwei isocyanatreaktiven Gruppen B) Polyester- und/oder Polycarbonat-Einheiten umfassen, und
wobei die molaren Verhältnisse von Isocyanatgruppen in A) zu gegenüber isocyanatreaktiven Gruppen in B) von 0,8 : 1,0 bis 1,3 : 1,0 betragen;
3) Anordnen des dielektrischen Elastomers zwischen die erste Elektrode und die zweite Elektrode.

8. Verfahren gemäß Anspruch 7, wobei das Bereitstellen des dielektrischen Elastomers erfolgt, indem eine zu dem Polyurethan-Polymer führende Reaktionsmischung auf die erste und/oder zweite Elektrode aufgetragen wird.

9. Verwendung eines dielektrischen Elastomers als Aktuator, Sensor und/oder Generator in einem elektromechanischen Wandler, wobei das dielektrische Elastomer ein Polyurethanpolymer umfasst, und das Polyurethanpolymer erhältlich ist aus der Reaktion von
A) trifunktionelles Polyisocyanat mit Biuret- und/oder Isocyanurat-Struktur
mit B) einer Verbindung mit mindestens zwei isocyanatreaktiven Gruppen,
wobei die Verbindung mit mindestens zwei isocyanatreaktiven Gruppen B) Polyester- und/oder Polycarbonat-Einheiten umfassen, und
wobei die molaren Verhältnisse von Isocyanatgruppen in A) zu gegenüber isocyanatreaktiven Gruppen in B) von 0,8 : 1,0 bis 1,3 : 1,0 betragen.

10. Elektrische und/oder elektronische Vorrichtung, umfassend einen elektromechanischen Wandler gemäß einem der Ansprüche 1 bis 6.

## Claims

1. An electromechanical converter, including a dielectric elastomer which is in contact with a first electrode and a second electrode, in which the dielectric elastomer includes a polyurethane polymer, **characterised in that** the polyurethane polymer can be obtained by reacting
A) trifunctional polyisocyanate having a biuret and/or isocyanurate structure
with B) a compound having at least two isocyanate-reactive groups,
in which the compound having at least two isocyanate-reactive groups B) includes polyester and/or polycarbonate units, and
in which the molar ratios of isocyanate groups in A) to isocyanate-reactive groups in B) are from 0.8 : 1.0 to 1.3 : 1.0.

2. An electromechanical converter according to Claim 1, in which component A) is based on an aliphatic trifunctional polyisocyanate having a biuret and/or isocyanurate structure.

3. An electromechanical converter according to Claim 1 or 2, in which component A) is based on hexamethylene diisocyanate.

4. An electromechanical converter according to one of Claims 1 to 3, **characterised in that** component B) is a polyester polyol and/or polycarbonate polyol.

5. An electromechanical converter according to one of Claims 1 to 4, in which the proportion of polyester and/or polycarbonate units in the polyurethane polymer is from ≥ 20 wt.% to ≤ 90 wt.%.

6. An electromechanical converter according to one of Claims 1 to 5, in which the polyurethane polymer has a modulus of elasticity at an extension of 50% of from ≥ 0.1 MPa to ≤ 15 MPa.

7. A method for producing an electromechanical converter, including the following steps:
1) preparation of a first electrode and a second electrode;
2) preparation of a dielectric elastomer, in which the dielectric elastomer includes a polyurethane polymer, and the polyurethane polymer can be obtained by reacting
A) trifunctional polyisocyanate having a biuret and/or isocyanurate structure
with B) a compound having at least two isocyanate-reactive groups,
in which the compound having at least two isocyanate-reactive groups B) includes polyester and/or polycarbonate units, and
in which the molar ratios of isocyanate groups in A) to isocyanate-reactive groups in B) are from 0.8 : 1.0 to 1.3 : 1.0;
3) disposition of the dielectric elastomer between the first electrode and the second electrode.

8. A method according to Claim 7, in which the dielectric elastomer is prepared by applying a reaction mixture that gives the polyurethane polymer to the first and/or second electrode.

9. Use of a dielectric elastomer as an actuator, sensor and/or generator in an electromechanical converter, in which the dielectric elastomer includes a polyurethane polymer and the polyurethane polymer can be obtained by reacting
A) trifunctional polyisocyanate having a biuret and/or isocyanurate structure
with B) a compound having at least two isocyanate-reactive groups,
in which the compound having at least two isocyanate-reactive groups B) includes polyester and/or polycarbonate units, and
in which the molar ratios of isocyanate groups in A) to isocyanate-reactive groups in B) are from 0.8 : 1.0 to 1.3 : 1.0.

10. An electrical and/or electronic device, including an electromechanical converter according to one of Claims 1 to 6.

## Revendications

1. Transducteur électromécanique, comprenant un élastomère diélectrique contacté par une première électrode et une deuxième électrode, l'élastomère diélectrique comprenant un polymère polyuréthane, **caractérisé en ce que** le polymère polyuréthane peut être obtenu à partir de la réaction de
A) un polyisocyanate trifonctionnel à structure de biuret et/ou d'isocyanurate
avec B) un composé comportant au moins deux groupes réactifs avec des isocyanates,
le composé qui comporte au moins deux groupes réactifs avec des isocyanates B) comprenant des motifs polyester et/ou polycarbonate, et
les rapports molaires des groupes isocyanate dans A) aux groupes réactifs vis-à-vis d'isocyanates dans B) valant de 0,8 : 1,0 à 1,3 : 1,0.

2. Transducteur électromécanique selon la revendication 1, dans lequel le composant A) est à base d'un polyisocyanate trifonctionnel aliphatique à structure de biuret et/ou d'isocyanurate.

3. Transducteur électromécanique selon la revendication 1 ou 2, dans lequel le composant A) est à base d'hexaméthylènediisocyanate.

4. Transducteur électromécanique selon l'une quelconque des revendications 1 à 3, **caractérisé en ce que** le composant B) est un polyester- et/ou polycarbonate-polyol.

5. Transducteur électromécanique selon l'une quelconque des revendications 1 à 4, dans lequel la proportion des motifs polyester et/ou polycarbonate dans le polymère polyuréthane vaut de ≥ 20 % en poids à ≤ 90 % en poids.

6. Transducteur électromécanique selon l'une quelconque des revendications 1 à 5, dans lequel le polymère polyuréthane présente un module d'élasticité à un allongement de 50 % de ≥ 0,1 Mpa à ≤ 15 MPa.

7. Procédé pour la fabrication d'un transducteur électromécanique, comprenant les étapes :
1) disposition d'une première électrode et d'une deuxième électrode ;
2) disposition d'un élastomère diélectrique, l'élastomère diélectrique comprenant un polymère polyuréthane, et le polymère polyuréthane pouvant être obtenu à partir de la réaction de
A) un polyisocyanate trifonctionnel à structure de biuret et/ou d'isocyanurate
avec B) un composé comportant au moins deux groupes réactifs avec des isocyanates,
le composé qui comporte au moins deux groupes réactifs avec des isocyanates B) comprenant des motifs polyester et/ou polycarbonate, et
les rapports molaires des groupes isocyanate dans A) aux groupes réactifs vis-à-vis d'isocyanates dans B) valant de 0,8 : 1,0 à 1,3 : 1,0 ;
3) placement de l'élastomère diélectrique entre la première électrode et la deuxième électrode.

8. Procédé selon la revendication 7, dans lequel on effectue la disposition de l'élastomère diélectrique en appliquant sur la première et/ou la deuxième électrode un mélange réactionnel conduisant au polymère polyuréthane.

9. Utilisation d'un élastomère diélectrique en tant qu'actionneur, capteur et/ou générateur dans un transducteur électromécanique, l'élastomère diélectrique comprenant un polymère polyuréthane, et le polymère polyuréthane pouvant être obtenu à partir de la réaction de
A) un polyisocyanate trifonctionnel à structure de biuret et/ou d'isocyanurate
avec B) un composé comportant au moins deux groupes réactifs avec des isocyanates,
le composé qui comporte au moins deux groupes réactifs avec des isocyanates B) comprenant des motifs polyester et/ou polycarbonate, et
les rapports molaires des groupes isocyanate dans A) aux groupes réactifs vis-à-vis d'isocyanates dans B) valant de 0,8 : 1,0 à 1,3 : 1,0.

10. Dispositif électrique et/ou électronique, comprenant un transducteur électromécanique selon l'une quelconque des revendications 1 à 6.
